# EUROPEAN PATENT APPLICATION

(11) **EP 4 546 459 A1**
(43) Date of publication of application: **30.04.2025**
(21) Application number: 22947419.2
(22) Date of filing: 24.06.2022
(51) Int. Cl.: H01M 4/38, H01M 4/58, H01M 4/587

(54) **SPHERICAL SILICON-BASED LITHIUM STORAGE MATERIAL AND PREPARATION METHOD THEREFOR**

(71) Applicant: Shanghai Shanshan Tech Co., Ltd., Pudong New Area Shanghai 201209 (CN)
(72) Inventor: MA, Fei, Shanghai 201209 (CN); WEI, Liangqin, Shanghai 201209 (CN); GAO, Min, Shanghai 201209 (CN); ZHANG, Xiuyun, Shanghai 201209 (CN); LI, Fengfeng, Shanghai 201209 (CN)
(74) Representative: karo IP
(86) International application number: PCT/CN2022/101242
(87) International publication number: WO 2023/245652

(57) **Abstract**

The application provides a spherical silicon-based lithium storage material and a preparation method thereof, wherein the preparation method comprises: providing a spherical matrix with a layered stacking structure; providing a spherical matrix with a layered stacking structure; performing different activation treatment steps to the spherical matrix by adopting an activation agent, and forming carbonaceous substance in pore channels formed by each activation treatment step; and forming silicon-containing substance in the pore channels after the different activation treatment steps and the carbonaceous substance is formed. The spherical silicon-based lithium storage material and the preparation method thereof of the technical scheme of the application may not only ensure the high sphericity of the material, but also improve the capacity of the material, and simultaneously, when being made into a lithium ion battery, the lithium ion battery may have excellent cycling performance and rapid rate charging performance.

## Description

### RELATED APPLICATIONS

### TECHNICAL FIELD

The disclosure relates to the field of lithium ion batteries, in particular to a spherical silicon-based lithium storage material and a preparation method thereof.

### BACKGROUND

At present, it is still difficult to industrially produce spherical silicon-based anode materials without edges and corners. The existing preparation methods still grind the edges and corners physically to improve the sphericity, which is not only limited in sphericity, but also requires secondary crushing, which makes the material utilization rate low and may not be popularized in industry.

The content of elemental silicon in the silicon-based anode material basically determines the reversible capacity of the anode after the lithium ion battery is made. However, limited by the manufacturing process, the content of elemental silicon particles in the spherical silicon-based anode material obtained by the prior art is limited, and the mass ratio of silicon element to oxygen element generally does not exceed 1.1 at the highest. Considering that it generally contains carbon element with a mass fraction of about 3%~5% in practical use, the silicon content is about 65% at the highest. Because there are a lot of oxygen, the gram capacity of the material generally does not exceed 1650 mAh/g.

### BRIEF SUMMARY

The present disclosure provides a spherical silicon-based lithium storage material and a preparation method thereof, which may not only ensure the high sphericity of the material, but also improve the capacity of the material, and simultaneously, when being made into a lithium ion battery, the lithium ion battery may have excellent cycling performance and rapid rate charging performance.

According to one aspect of the present disclosure, a preparation method for a spherical silicon-based lithium storage material is provided. The preparation method for a spherical silicon-based lithium storage material including: providing a spherical matrix with a layered stacking structure; performing different activation treatment steps to the spherical matrix by adopting an activation agent, and forming carbonaceous substance in pore channels formed by each activation treatment step; and forming silicon-containing substance in the pore channels after the different activation treatment steps and the carbonaceous substance is formed.

In some of the embodiment, the different activation treatment steps at least comprise: Performing the first activation treatment step at a first temperature for a first time, and forming the carbonaceous substance in the formed pore channels; and heating to a second temperature, performing the second activation treatment step for a second time, and continuing to form carbonaceous substance in the formed pore channels.

In some of the embodiment, the first temperature is 500°C~700°C, and the first time is 1h~5h; the second temperature is 710°C~950°C, and the second time is 0.1h~20h.

In some of the embodiment, after the first and the second activation treatment step and forming the carbonaceous substance, the different activation treatment steps further comprise: judging whether the next activation treatment step is needed according to the pore volume and sphericity of the material after the carbonaceous substance is formed in the previous steps.

In some of the embodiment, when the pore volume is less than 0.3g/cm³, or when the pore volume is equal to or more than 0.3g/cm³ and the sphericity is less than 0.7, it is determined that the next activation treatment step is needed; when the pore volume is equal to or more than 0.3g/cm³ and the sphericity is equal to or more than 0.7, it is determined that the next activation treatment step is unnecessary.

In some of the embodiment, the different activation treatment steps further comprises: if it is determined that next activation treatment step is needed, lowering the temperature and performing another activation treatment step, wherein the temperature drop range is 10°C~50°C, and the time is shortened by 0.5h~5h.

In some of the embodiment, the activation agent comprises at least one of H₂O, CO₂, ZnCl₂, K₂CO₃, KOH and H₃PO₄.

In some of the embodiment, the mass of the carbonaceous substance formed at each activation treatment step is 0.01%~5% of the total mass of the spherical silicon-based lithium storage material.

In some of the embodiment, depositing carbonaceous gas in the pore channels to form the carbonaceous substance, and the carbonaceous gas comprises at least one of methane, melamine, aniline, ethylene, acetylene, propane, propyne, methanol and fluorocarbon.

In some of the embodiment, the silicon-containing substance is formed by a plasma chemical vapor deposition process, and the mass of elemental silicon in the silicon-containing substance is 5%-78% of the total mass of the spherical silicon-based lithium storage material.

In some of the embodiment, during the plasma chemical vapor deposition process, the gas source for deposition comprises silicon source gas, or the gas source for deposition comprises silicon source gas and nitrogen source gas.

In some of the embodiment, during the plasma chemical vapor deposition process, the temperature is 400°C~750°C, the pressure is 50Pa~1000Pa, the gas flow ratio of the nitrogen source gas and the silicon source gas is 0.03~1, and the deposition time is 20~500 min.

In some of the embodiment, the nitrogen source gas comprises N₂ and/or NH₃, and the silicon source gas comprises at least one of SiH₄, SiHCl₃, SiH₂Cl₂, SiH₃Cl and SiCl₄.

In some of the embodiment, the spherical matrix is mesophase carbon microspheres which is treated by a pre-oxidation process; the preparation method of the spherical matrix comprises: providing mesophase carbon microspheres with a particle size of 1µm~50µm; performing the pre-oxidation process to the mesophase carbon microspheres, wherein the weight loss rate of the mesophase carbon microspheres after the pre-oxidation process is equal to or less than 2%, and the mass fraction of carbon element is equal to or more than 90%.

In some of the embodiment, the reagent of the pre-oxidation process comprises at least one of O₂, O₃ and N₂O, the temperature of the pre-oxidation process is 400°C~600°C, and the time of the pre-oxidation process is 1h~5h.

In some of the embodiment, after forming the silicon-containing substance, the preparation method further comprises: forming a carbon coating layer on the surface of the spherical matrix, and the temperature during forming the carbon coating layer is equal to or lower than 890°C.

In some of the embodiment, the carbon source gas for forming the carbon coating layer comprises at least one of methane, melamine, aniline, ethylene, acetylene, propane, propyne, methanol and fluorocarbon.

According to another aspect of the present disclosure, a spherical silicon-based lithium storage material is provided. The spherical silicon-based lithium storage material including: a spherical matrix with a layered stacking structure, wherein the spherical matrix comprises carbon, hydrogen, oxygen and sulfur, wherein the mass fraction of carbon is equal to or more than 90%, and the spherical matrix also include pore channels extending inward from the surface of the spherical matrix and distributed in layers, and the pore channels comprise carbonaceous substance and silicon-containing substance; and a carbon coating layer located on the surface of the spherical matrix.

In some of the embodiment, a part of channels located in different layers are interconnected.

In some of the embodiment, the pore volume of the pore channels is 0.5cm³/g~1.8cm³/g, wherein the volume fraction of the pore channels with the pore diameter less than 10nm is 50%-74%.

In some of the embodiment, the sizes of the carbonaceous substance and the silicon-containing substance are 0.05nm to 999nm, and the silicon-containing substance is in a silicon nanowire structure.

In some of the embodiment, the carbonaceous substance comprises at least one of elemental carbon, hydrocarbons, carbonitrides and fluorocarbons; the silicon-containing substance comprises elemental silicon and/or silicon nitride.

In some of the embodiment, the mass of the carbonaceous substance is 0.01%-5% of the total mass of the spherical silicon-based lithium storage material; the mass of elemental silicon in the silicon-containing substance is 5%-78% of the total mass of the spherical silicon-based lithium storage material.

In some of the embodiment, the mass of the carbon coating layer is 0.1%-10% of the total mass of the spherical silicon-based lithium storage material.

In some of the embodiment, the carbon coating layer comprises at least one of elemental carbon, hydrocarbons, carbonitrides and fluorocarbons.

Compared with the prior art, spherical silicon-based lithium storage material and a preparation method thereof in the applied technical scheme have the following beneficial effects:

Spherical matrix with layered stacking structure is used as the core of silicon-based lithium storage material, which lays a structural foundation for the subsequent activation treatment to form layered pore channels. Using pre-oxidized mesophase carbon microspheres as spherical matrix makes the surface of spherical matrix rich in oxygen-containing groups, such as carbonyl and carboxyl, which is beneficial to the effective activation process.

Performing different activation treatment steps to the spherical matrix, and after each activation treatment step, carbonaceous substance is formed in the formed pore channels, which may avoid the collapse of the spherical matrix during activation treatment, keep the spherical matrix with high sphericity and reduce the weight loss rate of the spherical matrix.

Layered pore channels are formed after different activation treatment steps, which is beneficial to the insertion and extraction of lithium ions. At the same time, because silicon-containing substance is also formed in the pore channels, spherical silicon-based lithium storage materials have higher capacity and excellent cycle performance and rapid charge performance.

### BRIEF DESCRIPTION OF THE DRAWINGS

The following drawings describe the exemplary embodiment disclosed in this application in detail. The same reference numerals indicate similar structures in several views of the drawings. Those skilled in the art may understand that these embodiments are non-limiting and exemplary embodiments. The drawings are only for the purpose of illustration and description, and are not intended to limit the scope of this application. Other embodiments may also fulfill the inventive intent of this application. It should be understood that the drawings are not drawn to scale.
FIG. 1 is a schematic flow chart of the preparation method of spherical silicon-based lithium storage material according to the embodiment of the present application;
FIG. 2 is a schematic structural diagram of a spherical silicon-based lithium storage material according to an embodiment of the present application.
FIG. 3 is a schematic diagram of the layered distribution of pore channels in the embodiment of the present application.
FIG. 4a is a scanning electron microscope image of mesophase carbon microspheres in Embodiment 1 of this application before pre-oxidation treatment;
FIG. 4b is a scanning electron microscope image of mesophase carbon microspheres in Embodiment 1 of this application after pre-oxidation treatment.
FIG. 5 is the XRD pattern of the material obtained in Embodiment 29;
FIG. 6 is a scanning electron microscope picture of the material obtained in Embodiment 33;
FIG. 7 is the N₂ adsorption-desorption curve of the material obtained in Embodiment 33;
FIG. 8 shows the pore size distribution of the material obtained in Embodiment 33;
FIG. 9 is a scanning electron microscope of the material obtained in Comparative 7;
FIG. 10 is the N₂ adsorption-desorption curve of the material obtained in Embodiment 49;
FIG. 11 shows the pore size distribution of the material obtained in Embodiment 62;
FIG. 12 is the XRD pattern of the material obtained in Embodiment 65;
FIG. 13 shows the pore size distribution of the material obtained in Embodiment 74;
FIG. 14 shows the pore size distribution of the material obtained in Embodiment 77;
FIG. 15 is a graph of 1C/1C cycle capacity retention rate of flexible battery made of materials obtained in Embodiment 62 and Comparative 18;
FIG. 16 is a charge-discharge curve of the material obtained in Embodiment 71.

### DETAILED DESCRIPTION

The following description provides the specific disclosure scenarios and requirements of this disclosure in order to enable those skilled in the art to make or use the contents of this disclosure. Various modifications to the disclosed embodiment will be apparent to those skilled in the art, and the general principles defined herein may be applied to other embodiment and without departing from the scope of this disclosure. Therefore, this disclosure is not limited to the illustrated embodiment, but is to be accorded the widest scope consistent with the claims.

In view of the low sphericity and capacity of the current silicon-based anode material, in the embodiment of the application, the pore channels are formed by performing different activation treatment steps to the spherical matrix, and at the same time, carbonaceous substance is filled in the pore channels formed by each step of activation treatment, thus the integrity of the spherical matrix may be kept to the greatest extent while the same pore volume is obtained, and the formed pore channels are layered structure, which is beneficial to the diffusion of lithium ions, and silicon-containing substance is formed in the pore channels after different activation treatment steps, thus the capacity of the material may be greatly improved, and when being made into a lithium ion battery, the lithium ion battery may have excellent cycling performance and rapid rate charging performance.

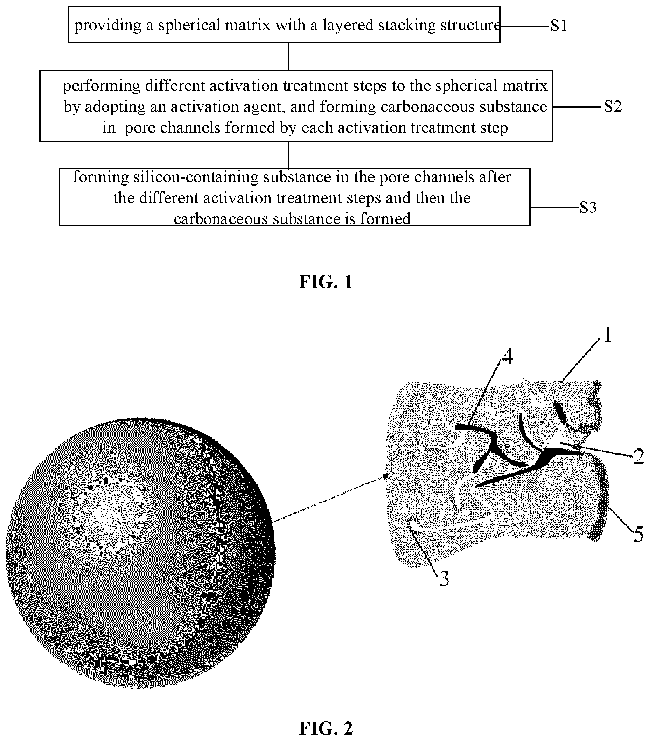

Referring to Fig. 1, the preparation method of the spherical silicon-based lithium storage material in the embodiment of the application includes the following steps:
Step 1: providing a spherical matrix with a layered stacking structure;
Step 2: performing different activation treatment steps to the spherical matrix by adopting an activation agent, and forming carbonaceous substance in pore channels formed by each activation treatment step;
Step 3: after the different activation treatment steps is finished and the carbonaceous substance is formed, silicon-containing substance is formed in the pore channels.

The spherical matrix may be mesophase carbon microspheres after a pre-oxidation treatment process. The mesophase carbon microspheres (MCMB) are micron-sized spherical carbon materials with nematic liquid crystal layered stacking structure generated by thermal polycondensation of heavy aromatic compounds such as asphalt. Compared with natural graphite, the mesophase carbon microspheres have large specific surface area, and the edge position of carbon layer and irregular defect position may provide lithium storage space, which has relatively high specific capacity.

In some embodiments, the spherical matrix is obtained by: providing mesophase carbon microspheres, which may be selected from commercially available products and have a particle size of 1µm~50µm. Then, the mesophase carbon microspheres are pre-oxidized to make the surface of the mesophase carbon microspheres rich in oxygen-containing groups, such as carbonyl groups and carboxyl groups, which is beneficial to the effective follow-up activation process. When performing pre-oxidation treatment, the reagent of the pre-oxidation process includes at least one of O₂, O₃ and N₂O, the temperature of the pre-oxidation process is 400°C~600°C, and the time of the pre-oxidation process is 1h-5h. For example, the temperature of the pre-oxidation process may be 400°C, 420°C, 440°C, 460°C, 480°C, 500°C, 520°C, 540°C, 560°C, 580°C, 600°C, or any temperature value between the above temperature nodes. the time of the pre-oxidation process may be 1h, 1.5h, 2h, 2.5h, 3h, 3.5h, 4h, 4.5h, 5h, or any time value between the above time nodes. the temperature of the pre-oxidation process and time have great influence on the weight loss rate of mesophase carbon microspheres. Too high pre-oxidation temperature or too long pre-oxidation time may lead to too large weight loss rate of mesophase carbon microspheres, which may damage the structure of mesophase carbon microspheres and cause serious material loss. After pre-oxidation treatment, the weight loss rate of the mesophase carbon microspheres is equal to or less than 2%, and the mass fraction of carbon element is equal to or more than 90%. The pre-oxidation treatment may be carried out in rotary kiln, fluidized bed, atmosphere furnace or dynamic furnace.

Compared with the method of forming spherical particles by physical pulverization, mesophase carbon microspheres are pre-oxidized as spherical matrix without secondary pulverization, which may not only maintain high sphericity, but also save the process of screening spherical particles and greatly improve the utilization rate of raw materials. In addition, because the mesophase carbon microspheres have a layered stacking structure, it lays a structural foundation for the formation of layered pores by activation treatment.

When performing a activation treatment to the spherical matrix with an activation agent, the activation agent reacts chemically with the spherical matrix, thus the surface of the spherical matrix is eroded, and then a developed pore channel structure is generated. However, there are still the following problems in the process of the activation treatment: firstly, because the surface of the spherical matrix is punctate erosion, the spherical matrix after the activation treatment is easy to collapse or its structure is seriously damaged, which greatly reduces the sphericity of the spherical matrix and leads to the decline of material properties. This is because, compared with angular silicon-based lithium storage materials, spherical silicon-based lithium storage materials are more uniform when the surface is covered with a carbon material layer, thus the phenomena of particle breakage and defect caused by repeated expansion-contraction may be better suppressed, thereby improving the cycle characteristics of lithium batteries. At the same time, spherical silicon-based lithium storage materials have high packing density, which may realize compact filling, and the spherical specific surface area is small, which may reduce irreversible capacity loss caused by side effects such as SEI film formed on the surface of electrolyte during charging, and may also improve lithium batteries. Secondly, because the mesophase carbon microspheres have a low degree of cross-linking, when the mesophase carbon microspheres are used as a spherical matrix, the weight loss of the spherical matrix is large, and the weight loss rate exceeds 60%.

In order to avoid the collapse of the spherical matrix during the activation treatment, maintain a high sphericity of the spherical matrix, and reduce the weight loss rate of the spherical matrix, the embodiment of the application performing different activation treatment steps on the spherical matrix, and after each activation treatment step, carbonaceous substance is formed in the formed pore channels.

The different activation treatment steps at least includes the first activation treatment step and the second activation treatment step. Firstly, the first activation treatment step is carried out, and the first activation treatment step is carried out at a first temperature for a first time, and carbonaceous substance is formed in the formed pore channels. Then, the temperature is raised from the first temperature to a second temperature, the second activation treatment step is carried out for a second time, and carbonaceous substance is formed in the formed pore channels. Ideally, each activation treatment step may form pore channels in the spherical matrix, and each time a carbonaceous substance is formed, not only the newly formed pore channels are filled, but also the pore channels formed before are filled. The carbonaceous substance may be cross-linked with the skeleton of the spherical matrix, thus the strength of the skeleton is improved, and the structural collapse phenomenon is obviously improved, therefore the spherical matrix may still maintain a high sphericity after the different activation treatment steps. At the same time, the spherical matrix with high sphericity has a good stacking state at high temperature, which further makes the cross-linking degree of the spherical matrix more sufficient and reduces the weight loss rate after activation.

The different activation treatment steps may be carried out in rotary kiln, fluidized bed, atmosphere furnace or dynamic furnace. The temperature and time of each activation treatment step affect the pore volume of the pore channels and need to be controlled within a reasonable range. When performing the first activation treatment step, the first temperature is 500°C~700°C, and the first time is 1h-5h. For example, the first temperature may be 500°C, 550°C, 600°C, 650°C, 700°C, or any temperature value between the above temperature nodes. The first time may be 1h, 1.5h, 2h, 2.5h, 3h, 3.5h, 4h, 4.5h, 5h, or any time value between the above time nodes. When performing the second activation treatment step, the second temperature is 710°C~950°C, and the second time is 0.1h~20h. For example, the second temperature may be 710°C, 730°C, 750°C, 770°C, 790°C, 800°C, 810°C, 830°C, 850°C, 870°C, 890°C, 910°C, 920°C, 950°C, or any temperature value between the above temperature nodes. The second time may be 0.1h, 1.5h, 2h, 2.5h, 3h, 3.5h, 4h, 4.5h, 5h, 6h, 7h, 8h, 9h, 10h, 11h, 12h, 13h, 14h, 15h, 16h, 17h, 18h, 19h, 20h, or any time value between the above time nodes. The activation agent may include at least one of H₂O, CO₂, ZnCl₂, K₂CO₃, KOH and H₃PO₄.

After the first and second activation treatment step and formation of carbonaceous substance, the different activation treatment steps may further include: judging whether the next activation treatment step is needed based on the pore volume and sphericity of the material after formation of carbonaceous substance in the previous step. When the pore volume is less than 0.3g/cm³, or when the pore volume is equal to or more than 0.3g/cm³ but the sphericity is less than 0.7, it is determined that the next activation treatment step is needed; when the pore volume is equal to or more than 0.3g/cm³ and the sphericity is equal to or more than 0.7, it is determined that the next activation treatment step is unnecessary. In the embodiment of the application, the target pore volume may be obtained by increasing the temperature during the second activation treatment step, but after the second activation treatment step, a developed pore channel structure is formed inside the spherical matrix. When a third activation treatment step and subsequent activation treatment step are carried out, if the temperature is continuously increased, the spherical matrix may be rapidly activated and the structure may collapse. Therefore, when it is determined that the next activation treatment step is needed, it is necessary to lower the activation temperature and shorten the activation time on the basis of the previous activation treatment step. The temperature drop range may be 10°C~50°C, and the time may be shortened by 0.5h~5h. That is to say, when the third activation treatment step and subsequent activation treatment step are carried out, the temperature is lower than that of the previous activation treatment step, and the time is correspondingly shortened.

The pore volume of the pore channel affects the capacity of spherical silicon-based lithium storage materials and the cycle performance of lithium-ion batteries. When the pore volume of the pore channel is larger, the capacity of the silicon-based lithium storage materials is increase, but it is not conducive to the improvement of the cycle performance of lithium-ion batteries. Therefore, the pore volume of the pore channel needs to be in a suitable range. The different activation treatment steps in the embodiment of the invention may form pore channels with appropriate pore channel volume in the spherical matrix, and at the same time, it may also increase the proportion of pore channels with the pore diameter less than 10nm. In some embodiments, the pore volume of the pore channels is 0.5cm³/g~1.8cm³/g, in which the volume fraction of the pore channels with the pore diameter less than 10nm is 50%~74%. When the pore channels with small pore diameter account for a relatively large proportion, the formation of large-sized carbonaceous substance and silicon-containing substance may be suppressed, which is beneficial to improving the fast charging performance of lithium ion batteries.

The spherical matrix includes a layered stacking structure. For example, when the spherical matrix is mesophase carbon microspheres, the chemical bond force of carbon atoms in the ordered carbon layers in the mesophase carbon microspheres is much greater than the intermolecular force between the ordered carbon layers, thus the pore channels are more likely to extend in the direction of parallel planes and present anisotropy, and the layered pore structure is beneficial to the insertion and extraction of lithium ions.

After each activation treatment step, carbonaceous gas is used to deposit in the pore channel to form the carbonaceous substance, and the carbonaceous gas includes at least one of methane, melamine, aniline, ethylene, acetylene, propane, propyne, methanol and fluorocarbon gas. The mass of the carbonaceous substance formed each time should not be too much, so as to avoid occupying too much pore channel space. In the embodiment of the application, the mass of the carbonaceous substance formed each time is 0.01%~5% of the total mass of the spherical silicon-based lithium storage material, so as to achieve the purpose of increasing the skeleton strength.

After the different activation treatment steps is finished and the carbonaceous substance is formed, the silicon-containing substance may be formed by a plasma chemical vapor deposition process, and the mass of elemental silicon in the silicon-containing substance is 5%-78% of the total mass of the spherical silicon-based lithium storage material, thus the spherical silicon-based lithium storage material has a higher capacity. When plasma chemical vapor deposition is performed, the gas source for deposition includes silicon source gas. In some embodiments, the gas source for deposition includes nitrogen source gas in addition to silicon source gas. The nitrogen source gas includes N₂ and/or NH₃, and the silicon source gas includes at least one of SiH₄, SiHCl₃, SiH₂Cl₂, SiH₃Cl and SiCl₄. When the gas source for deposition includes silicon source gas, the silicon-containing substance includes elemental silicon; when the gas source for deposition includes a silicon source gas and a nitrogen source gas, the silicon-containing substance includes at least one of elemental silicon and silicon nitride. When the silicon-containing substance includes both elemental silicon and silicon nitride, the spherical silicon-based lithium storage material has the best performance.

When plasma chemical vapor deposition is carried out, the nitrogen source gas and the silicon source gas may react at a lower temperature to form elemental silicon and amorphous silicon nitride with smaller size, thus the spherical silicon-based lithium storage material shows better rate fast charging performance when applied to lithium ion batteries. In the embodiment of the application, the size of the silicon-containing substance is controlled between 0.05nm and 999nm. Specifically, by controlling the temperature, pressure, time and gas flow ratio during plasma chemical vapor deposition, elemental silicon and silicon nitride with ideal size and ratio may be obtained. In some embodiments, the parameters of the plasma chemical vapor deposition process are controlled as follows: the temperature is 400°C~750°C, the pressure is 50Pa~1000Pa, the gas flow ratio of the nitrogen source gas and the silicon source gas is 0.03~1, and the deposition time is 20min~500min. Therefore, the sizes of the elemental silicon and the silicon nitride may be controlled not to exceed 20nm, and the high mass fraction of the elemental silicon may be ensured. At the same time, the silicon-containing substance obtained by the embodiment of the application is in a silicon nanowire structure. The spherical silicon-based lithium storage material obtained in the embodiment of the application is tested by X-ray diffraction full spectrum, and D<10nm is calculated by Scherrer formula D=Kλ/βcosθ, where D is the grain size, β is the integral half-width, θ is the diffraction angle, λ is the X-ray wavelength, and the λ value is 0.154056nm with a Cu target.

Because of the capillary action in the process of forming silicon-containing substance, it is more difficult to form silicon-containing substance closer to the inside of the channel; on the contrary, the farther away from the inside of the channel, the higher the deposition amount of silicon-containing substance. This concentration distribution of silicon may reduce the structural mutation caused by the sharp expansion of silicon in the porous core, thus stabilizing the surface structure of silicon-based lithium storage materials and improving the cycle stability of lithium-ion batteries.

After forming the silicon-containing substance, the preparation method further includes: forming a carbon coating layer on the surface of the spherical matrix, and the temperature during forming the carbon coating layer is equal to or lower than 890°C, which is lower than the crystal formation temperature of silicon nitride, thus the crystallization phenomenon of amorphous silicon nitride in the silicon-containing substance may be suppressed. As an example, the temperature at which the carbon coating layer is formed may be 750°C~890°C. The carbon source gas for forming the carbon coating layer may include at least one of methane, melamine, aniline, ethylene, acetylene, propane, propyne, methanol and fluorocarbon gas. As an example, when the carbon source gas includes at least one of methane, ethylene, acetylene, propane and propyne, the carbon source gas is adsorbed to the surface of the material and chemically reacts to generate elemental carbon and hydrogen; when the carbon source gas includes at least one of melamine and aniline, the product includes elemental carbon, carbonitride, hydrocarbon and hydrogen; when the carbon source gas includes methanol, the product includes elemental carbon and water; when the carbon source gas includes fluorocarbon gas, the product includes fluorocarbon. Therefore, the carbon coating layer of the embodiment of the present application may include at least one of elemental carbon, hydrocarbons, carbonitrides and fluorocarbon. The thickness of the carbon coating layer does not exceed 40nm.

The spherical silicon-based lithium storage material with a sphericity of equal to or more than 0.7 may be obtained by the preparation method of the embodiment of the application. The particle stacking of the spherical silicon-based lithium storage material is more sufficient, and the lithium evolution phenomenon caused by the expansion and contraction of the material is greatly alleviated; and the spherical silicon-based lithium storage material contains anisotropically distributed pore channels, and elemental silicon and silicon nitride are deposited in the pore channels, which is very suitable for lithium ion conduction under the condition of high-rate charging and discharging, and has obvious fast charging advantages. The surface of the spherical matrix is covered with carbon coating layer, which realizes the surface modification of nano-scale materials and avoids the reaction between silicon oxide materials and electrolyte during charging and discharging when used as electrode materials, thus it has good cycle stability; at the same time, the whole preparation process may be continuously produced, and the utilization rate of materials is high.

The embodiment of the application also provides a spherical silicon-based lithium storage material, which may be obtained by the above preparation method. Referring to Fig. 2, the spherical silicon-based lithium storage material includes a spherical matrix 1, which includes carbon, hydrogen, oxygen and sulfur, wherein the mass fraction of carbon is equal to or more than 90%. The spherical matrix 1 may be, for example, mesophase carbon microspheres that have been pre-oxidized. The spherical matrix 1 is also distributed with pore channels 2 extending inward from the surface of the spherical matrix 1 and distributed in layers. In some embodiments, the pore volume of the pore channels may be 0.5cm³/g~1.8cm³/g, which may give consideration to the capacity of spherical silicon-based lithium storage material and the cycle performance of lithium ion battery, wherein the volume fraction of the pore channels with the pore diameter less than 10nm may be 50%~74%, which is beneficial to restraining the size of the filling substance in the pore channels.

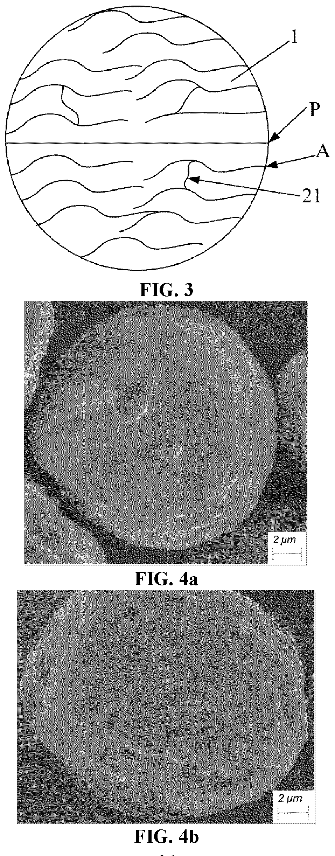

Because the spherical matrix 1 has a layered stacking structure, the pore channels 2 in the spherical matrix 1 are also layered. In order to understand the layered distribution pattern of the pore channels 2 conveniently, Fig. 3 schematically shows the cross-sectional view of the spherical matrix 1, and lines A represent the pore channels in the same layer. The lines shown in the figure are only schematic and do not represent the true morphology of the pore channels. The top view structure of the same layer of pore channels may be the pore channel structure shown in the partial enlarged view in Fig. 1. Fig. 3 also shows the equatorial plane P of the spherical matrix 1. In some embodiments, the extending direction of the pore channels 2 may be parallel to the equatorial plane P of the spherical matrix 1. In some embodiments, part of the pore channels 21 located in different layers communicate with each other.

Referring to Fig. 2, the pore channels 2 includes a carbonaceous substance 3 and a silicon-containing substance 4, and the sizes of the carbonaceous substance 3 and the silicon-containing substance 4 may range from 0.05nm to 999nm, wherein the small-sized carbonaceous substance 3 may save pore space, and the small-sized silicon-containing substance 4 may provide a good rate fast charge performance for lithium ion batteries. The silicon-containing substance 4 has a silicon nanowire structure. The carbonaceous substance 3 includes at least one of elemental carbon, hydrocarbons, carbonitrides and fluorocarbon. The silicon-containing substance 4 includes elemental silicon and/or silicon nitride. The mass of carbonaceous substance 3 affects the skeleton strength of spherical matrix 1, and the mass of elemental silicon affects the capacity of spherical silicon-based lithium storage material. In the embodiment of the application, the mass of the carbonaceous substance 3 is 0.01%-5% of the total mass of the spherical silicon-based lithium storage material, and the mass of the elemental silicon may be 5%-78% of the total mass of the spherical silicon-based lithium storage material.

The closer to the inside of the pore channel, the lower the concentration of the silicon element, which may reduce the structural mutation caused by the sharp expansion of silicon in the spherical matrix, thus stabilizing the surface structure of the spherical silicon-based lithium storage material and improving the cycle stability of the lithium ion battery.

With continued reference to Fig. 2, the spherical silicon-based lithium storage material further includes a carbon coating layer 5 located on the surface of the spherical matrix 1. The mass of the carbon coating layer 5 may be 0.1% to 10% of the total mass of the spherical silicon-based lithium storage material. The thickness of the carbon coating layer 5 may be 0.5nm to 10nm. The carbon coating layer 5 may include at least one of elemental carbon, hydrocarbons, carbonitrides and fluorocarbons. The carbon coating layer 5 may restrain and buffer the volume expansion of the spherical matrix 1, prevent the agglomeration of the spherical matrix 1, prevent the electrolyte from penetrating into the center of the spherical matrix 1, and maintain a stable interface and SEI.

### Embodiment 1~Embodiment 28

Mesophase carbon microspheres with a certain average particle size (Dv50) are pre-oxidized, in which the mass fraction of carbon element is 92%. the reagent of the pre-oxidation process, pre-oxidation temperature, pre-oxidation time and weight loss rate of mesophase carbon microspheres are shown in Table 1. FIG. 4a is a scanning electron microscope image of mesophase carbon microspheres in Embodiment 1 of this application before pre-oxidation treatment. FIG. 4b is a scanning electron microscope image of mesophase carbon microspheres in Embodiment 1 of this application after pre-oxidation treatment.

### Comparative 1~Comparative 4

Commercial coconut shell coke(Comparative 1), coal-series coke(Comparative 2), pitch carbon(Comparative 3) and petroleum coke(Comparative 4) with an average particle size of 10µm are pre-oxidized. the reagent of the pre-oxidation process, pre-oxidation temperature, pre-oxidation time and weight loss rate of mesophase carbon microspheres are shown in Table 1.

### Comparative 5

The spherical matrix of Embodiment 4 is used, but only heat treatment is carried out, and no pre-oxidation reagent is added. The heat treatment conditions and weight loss rate are shown in Table 1.

**Table 1: Treatment Conditions and Weight Loss Rate of Embodiment 1-28 and Comparative 1-5**

| Examples | Dv50 | the reagent of the pre-oxidation process | the temperature of the pre-oxidation process | the time of the pre-oxidation process | weight loss rate |
|---|---|---|---|---|---|
| | µm | / | °C | h | % |
| Embodiment 1 | 10 | O₂ | 420 | 2 | 0.3 |
| Embodiment 2 | 10 | O₂ | 450 | 2 | 0.36 |
| Embodiment 3 | 10 | O₂ | 520 | 2 | 0.45 |
| Embodiment 4 | 10 | O₂ | 550 | 2 | 0.56 |
| Embodiment 5 | 10 | O₂ | 500 | 4 | 0.62 |
| Embodiment 6 | 10 | O₂ | 500 | 5 | 0.71 |
| Embodiment 7 | 10 | O₃ | 500 | 6 | 0.56 |
| Embodiment 8 | 6 | O₂ | 420 | *2* | *0.42* |
| Embodiment 9 | 6 | O₂ | 450 | 2 | 0.52 |
| Embodiment 10 | 6 | O₂ | 520 | 2 | 0.58 |
| Embodiment 11 | 6 | O₂ | 550 | 2 | 0.72 |
| Embodiment 12 | 6 | O₂ | 500 | 4 | 0.8 |
| Embodiment 13 | 6 | O₂ | 500 | 5 | 0.92 |
| Embodiment 14 | 6 | O₃ | 500 | 6 | 0.64 |
| Embodiment 15 | 22 | O₂ | 420 | 2 | 0.23 |
| Embodiment 16 | 22 | O₂ | 450 | 2 | 0.28 |
| Embodiment 17 | 22 | O₂ | 520 | 2 | 0.37 |
| Embodiment 18 | 22 | O₂ | 550 | 2 | 0.45 |
| Embodiment 19 | 22 | O₂ | 500 | 4 | 0.51 |
| Embodiment 20 | 22 | O₂ | 500 | 5 | 0.63 |
| Embodiment 21 | 22 | O₃ | 500 | 6 | 0.61 |
| Embodiment 22 | 40 | O₂ | 420 | 2 | 0.18 |
| Embodiment 23 | 40 | O₂ | 450 | 2 | 0.2 |
| Embodiment 24 | 40 | O₂ | 520 | 2 | 0.3 |
| Embodiment 25 | 40 | O₂ | 550 | 2 | 0.38 |
| Embodiment 26 | 40 | O₂ | 500 | 4 | 0.45 |
| Embodiment 27 | 40 | O₂ | 500 | 5 | 0.49 |
| Embodiment 28 | 40 | O₃ | 500 | 6 | 0.51 |
| Comparative 1 | 10 | O₂ | 550 | *2* | 1.92 |
| Comparative 2 | 10 | O₂ | 550 | 2 | 3.24 |
| Comparative 3 | 10 | O₂ | 550 | 2 | 4.23 |
| Comparative 4 | 10 | O₂ | 550 | 2 | 3.25 |
| Comparative 5 | 10 | / | 550 | 2 | 0.11 |

Embodiment 1-28 used mesophase carbon microspheres as spherical matrix for pre-oxidation, and the weight loss rate is less than 1%. However, in Comparative 1-4, when the spherical matrix is changed from mesophase carbon microspheres to commercial coconut shell carbon, coal-series coke, pitch carbon and petroleum coke, the weight loss rate exceeded 1%, and most of them exceeded 2%. Compared with Embodiment 4, the weight loss rate of Comparative 5 is reduced to 0.11% only by heat treatment without the participation of pre-oxidation reagent, which indicated that the reagent of the pre-oxidation process could react with the matrix material and enrich the surface groups of the matrix material, which is beneficial to the subsequent step-by-step activation effect.

### Embodiment 29~Embodiment 34

The powder obtained in Embodiment 3 is subjected to the first activation treatment step (activation 1) and the second activation treatment step (activation 2) in turn, and no filling treatment is carried out after each activation treatment step. The activation reagent, temperature, time, weight loss rate of the material after different activation treatment steps and pore conditions are shown in Table 2.

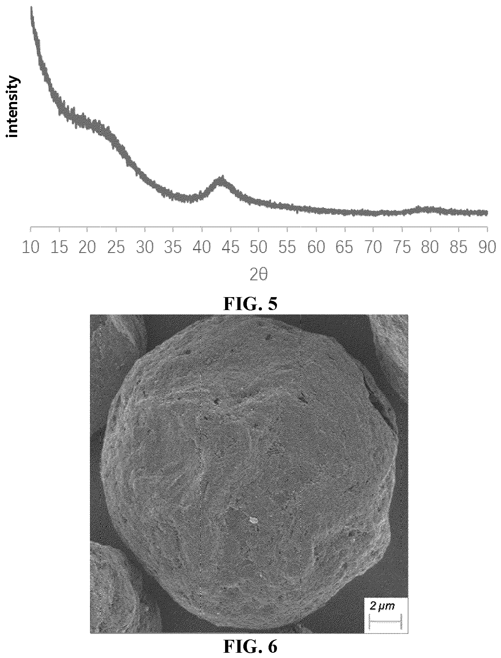

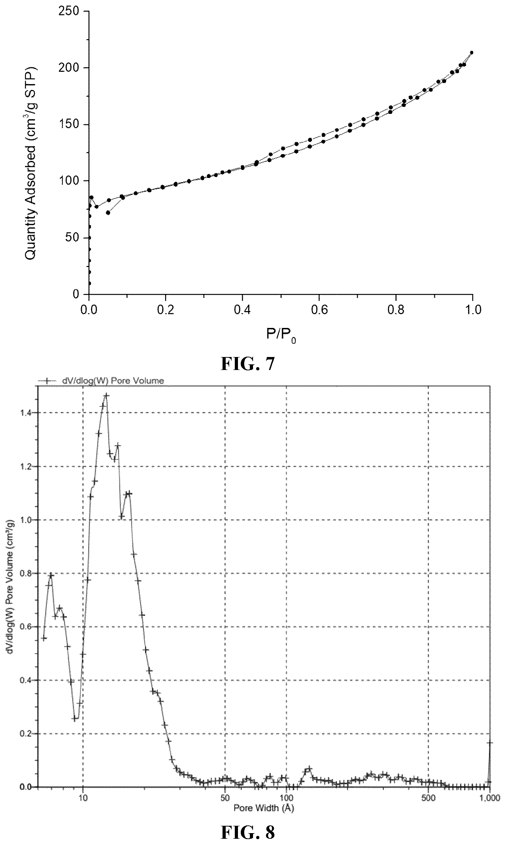

According to Embodiment 29~33, the higher the activation temperature, the higher the weight loss rate, but the weight loss rate remains at a low value, and the pore volume of the pore channels also increases accordingly. Fig. 5 shows the XRD pattern of the material obtained in Embodiment 29, which shows that the material has typical carbon with low crystallinity. Fig. 6 shows the scanning electron microscope image of the material obtained in Embodiment 33 (the first and the second activation treatment step and not filled with silicon-containing substance). It may be seen that after the first and the second activation treatment step, the spherical matrix still maintains almost complete spherical structure and has a high sphericity. Fig. 7 shows the N₂ adsorption-desorption curve of the material obtained in Embodiment 33, and a typical H4-type "hysteresis loop" appears in the range of P/P0=0.42 to 0.95. Fig. 8 shows the pore size distribution of the material obtained in Embodiment 33, and it may be seen that the pore channels of the material are mainly composed of micropores. Because the filling amount of carbonaceous substance is small, micropores are mainly used before the filling of silicon-containing substance,

Compared with Embodiment 32 and Embodiment 34, keeping the activation atmosphere and temperature constant and prolonging the activation time, both the weight loss rate and the pore volume of the pore channel increase, but the weight loss rate remains at a low value.

### Embodiment 35~Embodiment 38

The powder obtained in Embodiment 3 is activated in the first activation treatment step (activation 1), and then carbonaceous gas is used as a filling reagent to form carbonaceous substance in the pore channels; continue to raise the temperature to perform the second activation treatment step (activation 2), and deposit carbonaceous substances in the pore channels again. The activation agent, temperature, time, filling agent, filling amount, weight loss rate of the material after the first and the second activation treatment step and pore conditions may be referred to Table 2, wherein the filling amount refers to the percentage of the mass of carbonaceous substance to the total mass of the material.

Compared with Embodiment 34, Embodiment 35 filled the formed pore channels with carbonaceous substance after each step of activation treatment, which significantly reduced the weight loss rate after step-by-step activation, which is beneficial to improve the yield of materials and reduce the cost.

Compared with Embodiment 35, Embodiment 36 increased the filling amount in the first step (Filling 1), reduced the weight loss rate of the material by 4%, and did not significantly reduce the pore volume.

### Embodiment 39~Embodiment 41

The activation agent is changed to H₂O, and other parameters are shown in Table 2. Compared with the material when the activation agent is CO₂, the pore volume is slightly increased, and the proportion of micropores is reduced, while the proportion of mesopores is increased.

### Embodiment 42

The activation agent is changed to KOH, and other parameters are shown in Table 2.

### Embodiment 43

The activation agent is changed to KOH, and adds the third activation treatment step(activation 3) and the third filling (filling 3). Other parameters are shown in Table 2.

### Embodiment 44

The activation agent is changed to KOH, and adds the third activation treatment step(activation 3) , and no filling is carried out after each activation treatment step. Other parameters are shown in Table 2.

Compared with the previous Embodiment which used H₂O or CO₂ as activation agent, Embodiment 42-44 used KOH as activation agent, which resulted in larger pore volume, but the number of pore channels smaller than 10nm decreased.

### Comparative 6

Compared with Embodiment 33, only one-step low-temperature activation treatment is adopted, and the formed pore channel could not reach the target pore volume.

### Comparative 7

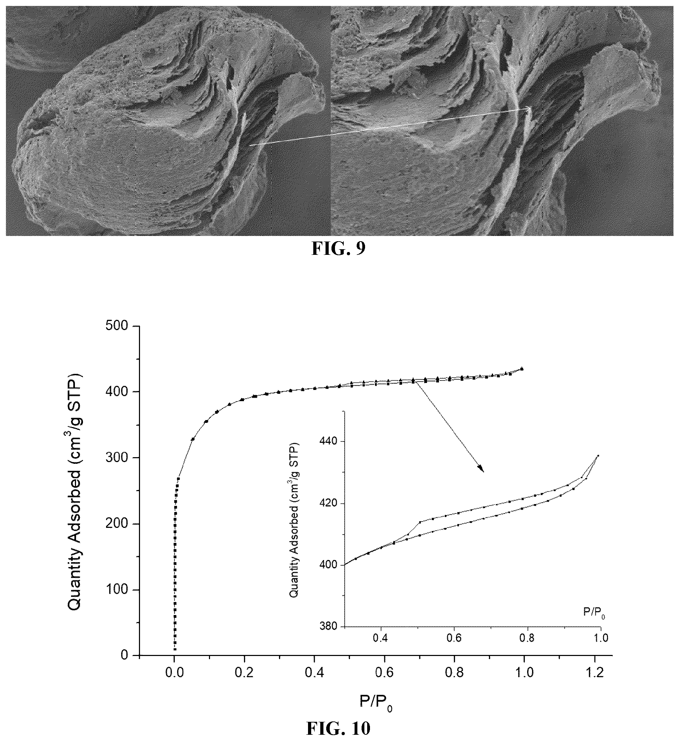

Compared with Embodiment 33, only one-step high-temperature activation treatment is adopted, and the proportion of pore channels smaller than 10nm is lower and the proportion of macropores is more. Fig. 9 is a scanning electron microscope image of the material obtained in Comparative 7, and it may be seen that the spherical matrix has collapsed seriously.

### Comparative 8

Compared with Embodiment 39, the proportion of pore channels smaller than 10nm is lower and the proportion of macropores is more by one-step high temperature activation treatment.

### Comparative 9 and Comparative 10

Compared with Embodiment 42, by one-step high-temperature activation treatment, the proportion of pore channels smaller than 10nm is lower and the proportion of macropores is more.

### Embodiment 45-60 and Comparative 11-15

The powder obtained in Embodiment 12 is activated, and the specific parameters are shown in Table 3. Fig. 10 is the N₂ adsorption-desorption curve of the material obtained in Embodiment 49 (not filled with silicon-containing substance), and a typical H4-type "hysteresis loop" appears in the range of P/P0=0.5 to 0.95.

### Embodiment 61-Embodiment100

Filling with silicon-containing substance and coating with carbon material layer, with specific parameters as shown in Table 4. The content of elemental silicon in Table 4 refers to the percentage of the mass of elemental silicon to the total mass of the material, and the analysis results of ICP (Inductively Coupled Plasma Spectroscopy), XRF(X-ray Fluorescence Spectroscopy) and XPS(X-ray Photoelectron Spectroscopy) are listed in Table 4.

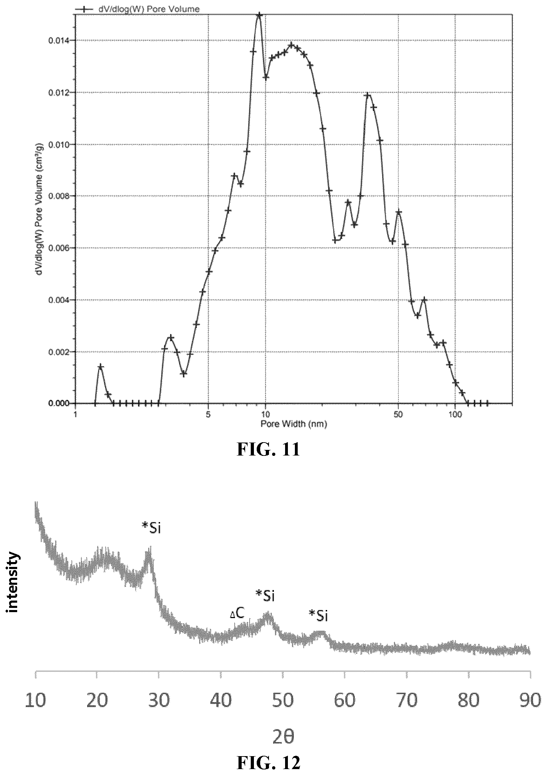

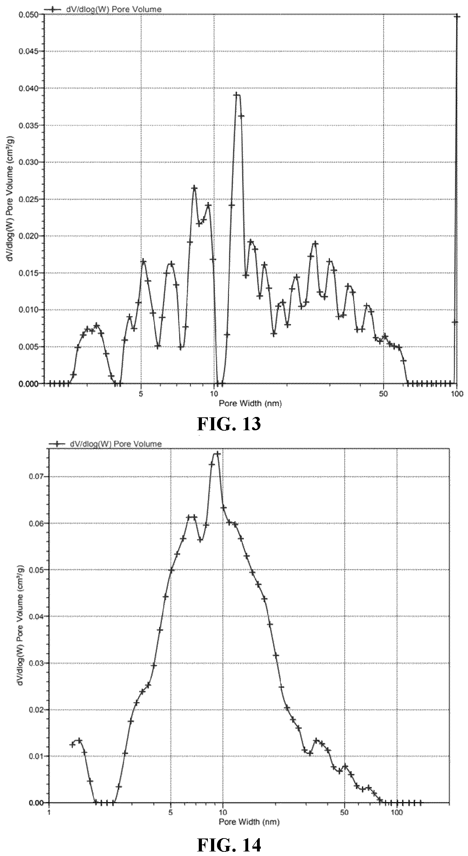

Fig. 11 is the pore size distribution diagram of the material obtained in Embodiment 62. It may be seen that the pore volume of the material is significantly reduced after the deposition of carbonaceous materials. Fig. 12 is an XRD pattern of silicon and nitrogen compounds deposited in Embodiment 65. Fig. 13 shows the pore size distribution of the material obtained in Embodiment 74, which is similar to that in Embodiment 62, because the carbonaceous material is filled after activation, resulting in a more dispersed pore size distribution of the material after deposition of silicon-containing material. Fig. 14 is the pore size distribution diagram of the material obtained in Embodiment 77. The pore volume of the material after CH₃OH deposition is drastically reduced, but the pore size distribution is concentrated around 1nm.

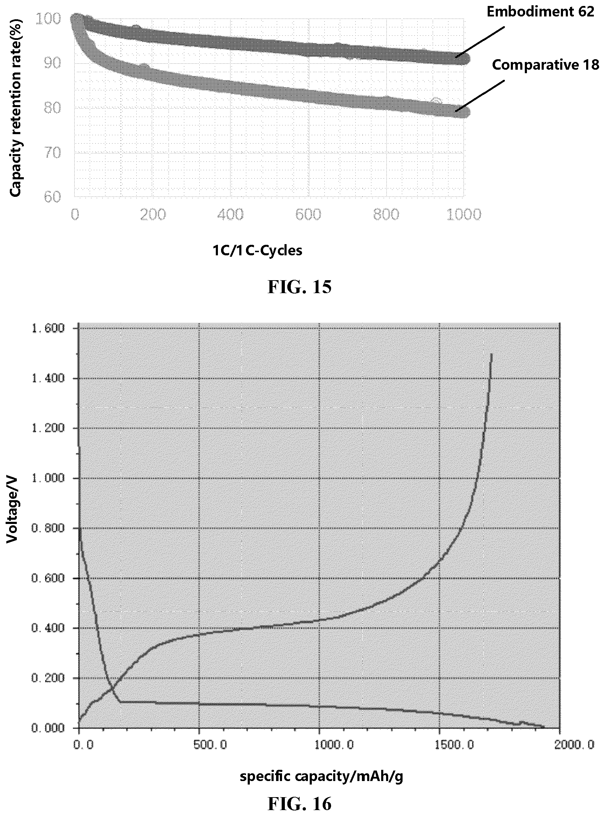

Fig. 15 is a graph of 1C/1C cycle capacity retention rate of flexible battery made of materials obtained in Embodiment 62 and Comparative 18. It may be seen that under the same deposition conditions of silicon-containing substance, the capacity retention rate of the full battery made of the material obtained in Comparative 18 after 1000 cycles is much lower than that of Embodiment 62, which shows that the different activation treatment steps method may significantly improve the cycle performance of the battery. Referring to Table 4, the 3C/0.2C volume ratio of Embodiment 62 is 76.4%, while that of Comparative 18 is only 56.2%. This may be because the different activation treatment steps may keep the matrix with high sphericity and make the pore distribution more complete, thus significantly improving the fast charging performance of the material. Fig. 12 shows the charge-discharge curve of the material obtained in Embodiment 71.

The materials obtained in Embodiment 61-100 and Comparative 16-21, PAA (polyacrylic acid binder) and SP (conductive carbon black) are mixed in the mass ratio of 80:10:10, and LiPF6 with 1mol/L is used as electrolyte to apply to the battery system (model CR2430), and the following electrochemical performance tests are conducted at 25°C:
(1) Capacity (first lithium removal capacity) and efficiency test: discharge 10mV at constant current of 0.1C, let stand for 10min, and then continue to discharge to 5mV at constant current of 0.02C; let it stand for 10 minutes, and then charge it to 1.5V at a constant current of 0.1C, the results are shown in Table 4.
(2) Cyclic performance test: discharge 10mV at constant current of 0.1C, let stand for 10min, and then continue to discharge to 5mV at constant current of 0.02C; let it stand for 10 minutes, then charge it to 1.5V at a constant current of 0.1C, and carry out subsequent cycles. The lithium removal capacity corresponding to the number of cycles/the lithium removal capacity in the second cycle is regarded as the cycle retention rate, and the results are shown in Table 4.
(3) Rate fast charge performance test: rate discharge (lithium intercalation, which corresponds to the whole battery charging process): charge at 0.2C (lithium removal) and discharge at 3.0C (lithium intercalation) to obtain the capacity ratio, and the results are shown in Table 4.

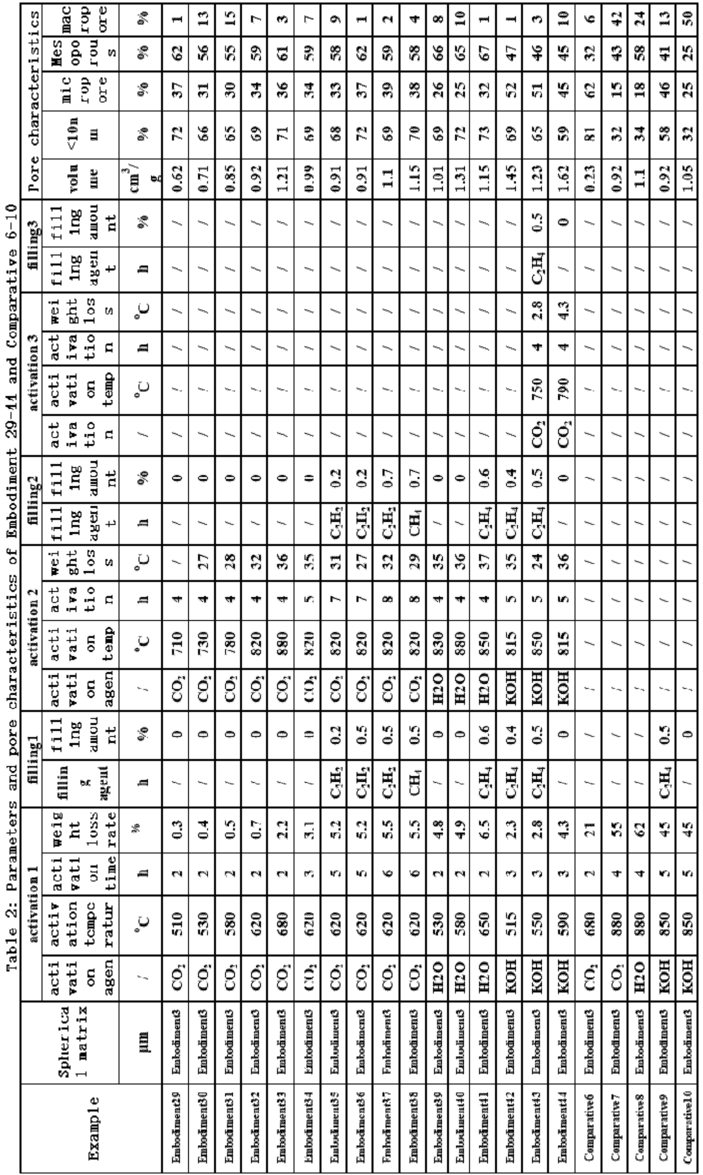

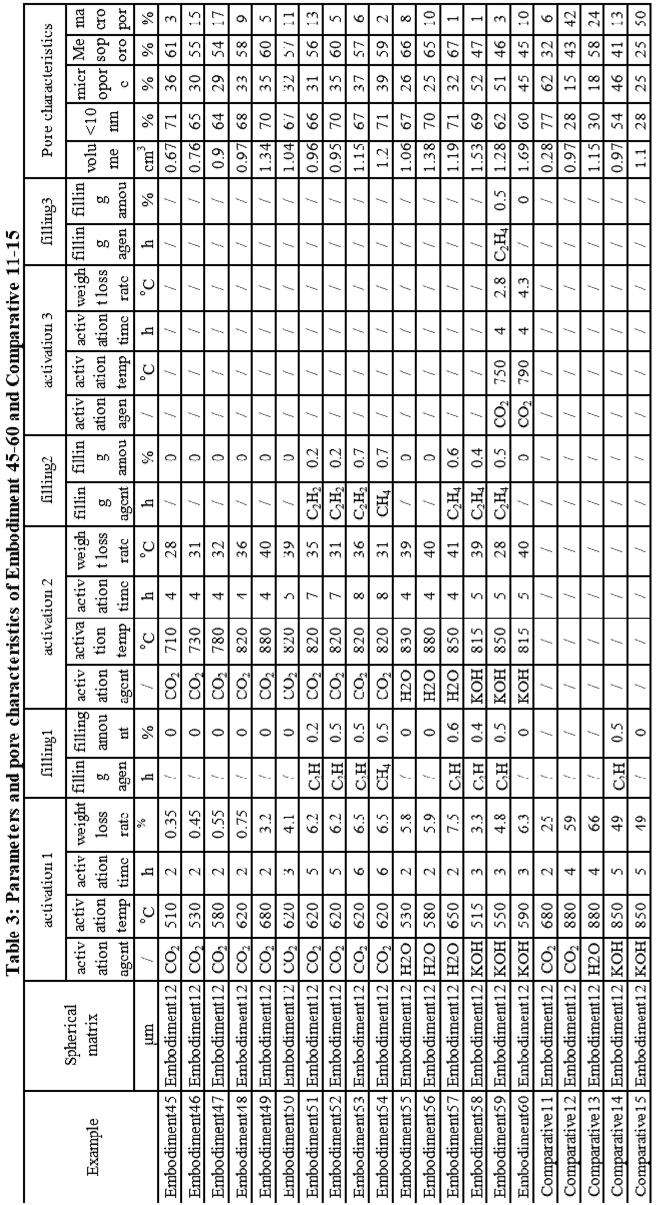

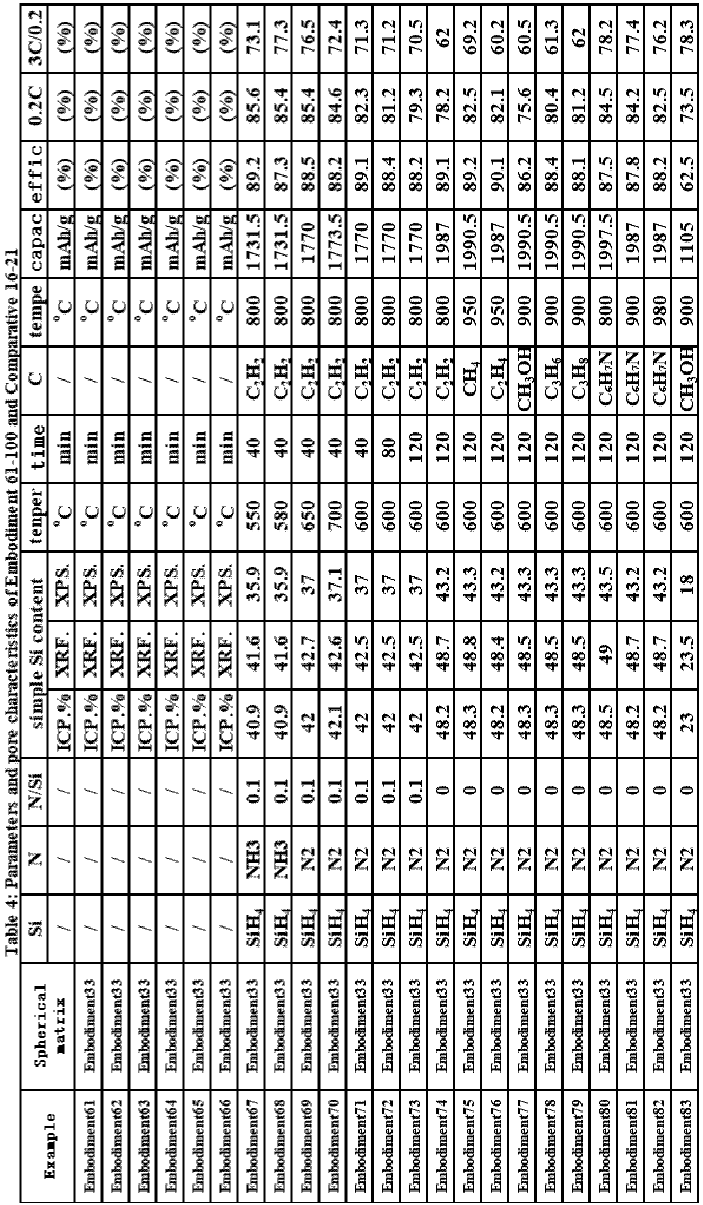

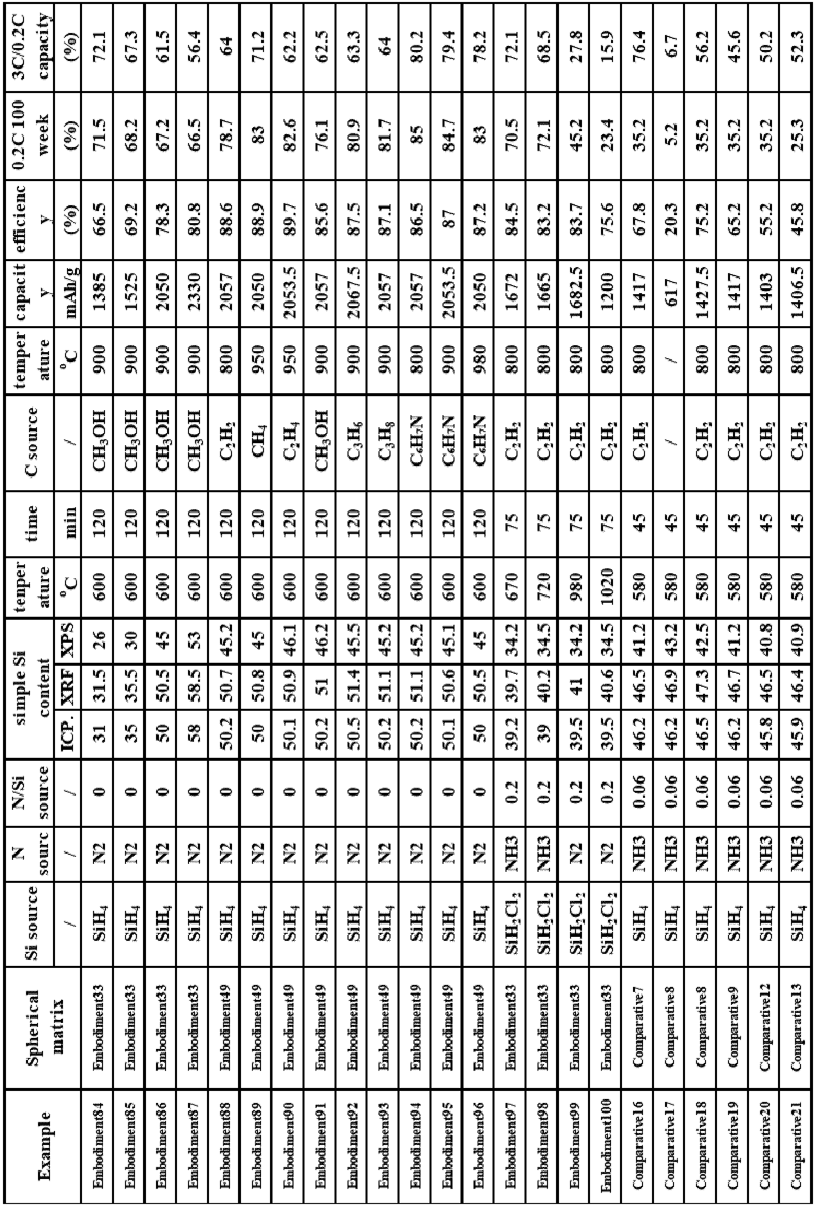

Finally, it should be understood that the example of the application disclosed herein is a description of the principle of the embodiment of the application. Other modified embodiments also fall within the scope of this application. Therefore, the embodiments disclosed in this application are only examples and not limitations. A person skilled in the art may implement the application in this application by adopting alternative configurations in accordance with the embodiments in this application. Therefore, embodiments of this application are not limited to those embodiments precisely described in the application.

## Claims

1. A preparation method for a spherical silicon-based lithium storage material,
**characterized in that**, comprising:
providing a spherical matrix with a layered stacking structure;
performing different activation treatment steps to the spherical matrix by adopting an activation agent, and forming carbonaceous substance in pore channels formed by each activation treatment step; and
forming silicon-containing substance in the pore channels after the different activation treatment steps and then the carbonaceous substance is formed.

2. The preparation method according to claim 1, **characterized in that**, the different activation treatment steps at least comprise:
Performing the first activation treatment step at a first temperature for a first time, and forming the carbonaceous substance in the formed pore channels; and
heating to a second temperature, performing the second activation treatment step for a second time, and continuing to form carbonaceous substance in the formed pore channels.

3. The preparation method according to claim 2, **characterized in that**, the first temperature is 500°C~700°C, and the first time is 1h~5h; the second temperature is 710°C~950°C, and the second time is 0.1h~20h.

4. The preparation method according to claim 2, **characterized in that**, after the first and the second activation treatment step and forming the carbonaceous substance, the different activation treatment steps further comprise: judging whether the next activation treatment step is needed according to the pore volume and sphericity of the material after the carbonaceous substance is formed in the previous steps.

5. The preparation method according to claim 4, **characterized in that**, when the pore volume is less than 0.3g/cm³, or when the pore volume is equal to or more than 0.3g/cm³ and the sphericity is less than 0.7, it is determined that the next activation treatment step is needed; when the pore volume is equal to or more than 0.3g/cm³ and the sphericity is equal to or more than 0.7, it is determined that the next activation treatment step is unnecessary.

6. The preparation method according to claim 4, **characterized in that**, the different activation treatment steps further comprises:
if it is determined that next activation treatment step is needed,
lowering the temperature and performing another activation treatment step, wherein the temperature drop range is 10°C~50°C, and the time is shortened by 0.5h~5h.

7. The preparation method according to claim 1, **characterized in that**, the activation agent comprises at least one of H₂O, CO₂, ZnCl₂, K₂CO₃, KOH and H₃PO₄.

8. The preparation method according to claim 1, **characterized in that**, the mass of the carbonaceous substance formed at each activation treatment step is 0.01%~5% of the total mass of the spherical silicon-based lithium storage material.

9. The preparation method according to claim 8, **characterized in that**, depositing carbonaceous gas in the pore channels to form the carbonaceous substance, and the carbonaceous gas comprises at least one of methane, melamine, aniline, ethylene, acetylene, propane, propyne, methanol and fluorocarbon.

10. The preparation method according to claim 1, **characterized in that**, the silicon-containing substance is formed by a plasma chemical vapor deposition process, and the mass of elemental silicon in the silicon-containing substance is 5%-78% of the total mass of the spherical silicon-based lithium storage material.

11. The preparation method according to claim 10, **characterized in that**, during the plasma chemical vapor deposition process, the gas source for deposition comprises silicon source gas, or the gas source for deposition comprises silicon source gas and nitrogen source gas.

12. The preparation method according to claim 11, **characterized in that**, during the plasma chemical vapor deposition process, the temperature is 400°C~750°C, the pressure is 50Pa~1000Pa, the gas flow ratio of the nitrogen source gas and the silicon source gas is 0.03~1, and the deposition time is 20~500 min.

13. The preparation method according to claim 11, **characterized in that**, the nitrogen source gas comprises N₂ and/or NH₃, and the silicon source gas comprises at least one of SiH₄, SiHCl₃, SiH₂Cl₂, SiH₃Cl and SiCl₄.

14. The preparation method according to claim 1, **characterized in that**, the spherical matrix is mesophase carbon microspheres which is treated by a pre-oxidation process; the preparation method of the spherical matrix comprises:
providing mesophase carbon microspheres with a particle size of 1µm~50µm;
performing the pre-oxidation process to the mesophase carbon microspheres, wherein the weight loss rate of the mesophase carbon microspheres after the pre-oxidation process is equal to or less than 2%, and the mass fraction of carbon element is equal to or more than 90%.

15. The preparation method according to claim 14, **characterized in that**, the reagent of the pre-oxidation process comprises at least one of O₂, O₃ and N₂O, the temperature of the pre-oxidation process is 400°C~600°C, and the time of the pre-oxidation process is 1h~5h.

16. The preparation method according to claim 1, **characterized in that**, after forming the silicon-containing substance, the preparation method further comprises: forming a carbon coating layer on the surface of the spherical matrix, and the temperature during forming the carbon coating layer is equal to or lower than 890°C.

17. The preparation method according to claim 16, **characterized in that**, the carbon source gas for forming the carbon coating layer comprises at least one of methane, melamine, aniline, ethylene, acetylene, propane, propyne, methanol and fluorocarbon.

18. A spherical silicon-based lithium storage material, **characterized in that**, comprising:
a spherical matrix with a layered stacking structure, wherein the spherical matrix comprises carbon, hydrogen, oxygen and sulfur, wherein the mass fraction of carbon is equal to or more than 90%, and the spherical matrix also include pore channels extending inward from the surface of the spherical matrix and distributed in layers, and the pore channels comprise carbonaceous substance and silicon-containing substance; and
a carbon coating layer located on the surface of the spherical matrix.

19. The spherical silicon-based lithium storage material according to claim 18, **characterized in that**, part of channels located in different layers are interconnected.

20. The spherical silicon-based lithium storage material according to claim 18, **characterized in that**, the pore volume of the pore channels is 0.5cm³/g~1.8cm³/g, wherein the volume fraction of the pore channels with the pore diameter less than 10nm is 50%-74%.

21. The spherical silicon-based lithium storage material according to claim 18, **characterized in that**, the sizes of the carbonaceous substance and the silicon-containing substance are 0.05nm to 999nm, and the silicon-containing substance is in a silicon nanowire structure.

22. The spherical silicon-based lithium storage material according to claim 18, **characterized in that**, the carbonaceous substance comprises at least one of elemental carbon, hydrocarbons, carbonitrides and fluorocarbons; the silicon-containing substance comprises elemental silicon and/or silicon nitride.

23. The spherical silicon-based lithium storage material according to claim 18, **characterized in that**, the mass of the carbonaceous substance is 0.01%-5% of the total mass of the spherical silicon-based lithium storage material; the mass of elemental silicon in the silicon-containing substance is 5%-78% of the total mass of the spherical silicon-based lithium storage material.

24. The spherical silicon-based lithium storage material according to claim 18, **characterized in that**, the mass of the carbon coating layer is 0.1%-10% of the total mass of the spherical silicon-based lithium storage material.

25. The spherical silicon-based lithium storage material according to claim 18, **characterized in that**, the carbon coating layer comprises at least one of elemental carbon, hydrocarbons, carbonitrides and fluorocarbons.
